# NEW EUROPEAN PATENT SPECIFICATION

(11) **EP 2 312 204 B2**
(45) Date of publication and mention of the opposition decision: **23.08.2017**
(45) Mention of the grant of the patent: 22.01.2014
(21) Application number: 10187816.3
(22) Date of filing: 15.10.2010
(51) Int. Cl.: F21S 8/10, F21V 29/00

(54) **A lighting device for vehicles, in particular motor vehicles, that uses leds**
LED Fahrzeugleuchte, insbesondere Kraftfahrzeugleuchte
Dispositif d'éclairage de véhicules avec DEL, en particulier pour les véhicules automobiles

(30) Priority: 16.10.2009 IT TO20090784
(43) Date of publication of application: 20.04.2011
(73) Proprietor: Automotive Lighting Italia S.p.A., 10078 Venaria Reale (Torino) (IT)
(72) Inventor: Pairetti, Alberto, 10064 Pinerolo (IT); Benfatto, Fabio, 20099 Sesto San Giovanni (IT)
(74) Representative: Bergadano, Mirko

(56) References cited:
- EP-A1- 0 531 186
- EP-A1- 2 020 567
- EP-A2- 1 762 432
- WO-A1-2005/108203
- CA-A1- 1 171 549
- US-A- 5 038 255
- US-A1- 2009 046 458

## Description

The present invention relates to a lighting device for vehicles, in particular motor vehicles, that uses LEDs.

Prior art lighting devices for vehicles comprise a body generally made of plastic material defining a front opening closed by a transparent element and housing a light source formed by a plurality of LEDs normally arranged according to a matrix-type structure.

The LEDs are arranged on a printed circuit which forms the relative electro-thermal connection.

As is known, the luminous flux and colour of the LEDs depend on the operating temperature; solid state light sources must also be provided with an appropriate heat dissipating element.

According to the prior art, the heat generated by the LEDS and which passes through the printed circuit is dissipated by a metal radiating element, thermally coupled to the printed circuit and housed in the plastic body. In particular, especially in automobile applications, the metal radiating element is arranged inside the plastic body at a distance from the walls of the latter so as to form a gap through which the air, warmed by the radiating element, can flow. A thermal interfacing material is normally used to improve the thermal contact between the radiating element and the printed circuit. Said thermal interfacing material may be a fluid material (adhesive, paste) or solid material (tape, gap filler).

The presence of a metal radiating element makes the lighting device relatively complex, heavy and bulky. Moreover, there is the problem of having to transmit at least some of the heat that is produced to the outside of the headlight or vehicle light, by means of air venting devices, also to prevent the formation of humidity and condensation inside the vehicle light assembly. EP-A-1762432 does not overcome these problems. EP0531186 and US5038255 show printed circuits provided direcly on a plastic body. CA 1171549 shows a printed circuit having tracks made by serigraphy.

The object of the present invention is to produce a lighting device that has a more simple structure, is smaller, lighter and cheaper to produce.

This object is achieved with the present invention which relates to a lighting device for vehicles, in particular motor vehicles, according to claim 1.

In particular, the lighting device comprises a body made of plastic material defining a front opening closed by a transparent element and housing a light source formed by a plurality of LEDs placed on a printed circuit arranged in thermal contact with the plastic body, or a portion thereof, that forms a radiating element to dissipate the heat generated by said LEDs to the outside.

A lighting device will now be described with particular reference to the accompanying drawings in which:
figure 1 is a side view of a lighting device for vehicles;
figure 2 is an enlarged scale view of a detail of an alternative embodiment of the device of figure 1; and
figure 3 shows the same detail of figure 2 of a further possible alternative embodiment of the device of figure 1.

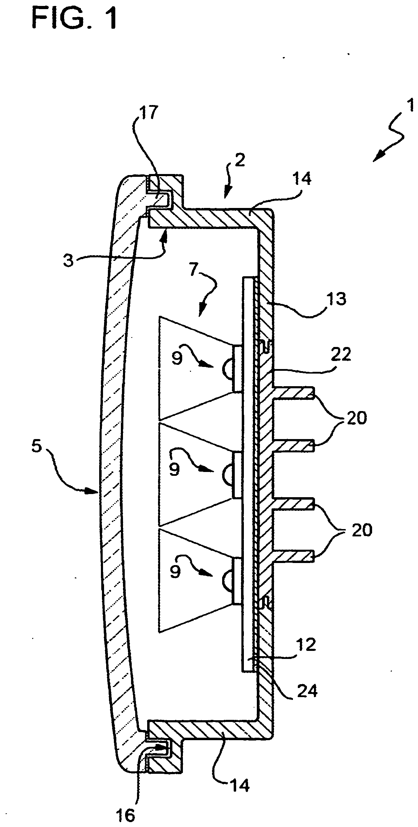

With reference to figure 1, designated as a whole by number 1 is a lighting device for vehicles, in particular motor vehicles, that uses LEDs.

The device 1 comprises a body 2 (generally made of plastic material, for example ABS, PP, PC, etc.) defining a front opening 3 closed by a transparent element or lens 5 and housing a light source 7 possibly formed by a plurality of LEDs 9 arranged according to a matrix structure, mounted on a printed circuit.

As is known, LED is the acronym for light-emitting diode; in recent years LEDs have been increasingly used in lighting applications, where characteristics such as high reliability, long life, high efficiency and low power consumption are required.

The LEDs 9 are arranged on a printed circuit 12 which forms the relative electro-thermal connection (not illustrated).

In the example that is illustrated, the plastic body 2 comprises a flat rear wall 13 integral with a side wall 14 arranged transversely with respect to the flat rear wall 13. The side wall 14 has a free end which delimits the opening 3 and defines a depressed annular seat 16 for housing a peripheral annular lip 17 of the transparent element 5.

The printed circuit 12 is arranged in direct thermal contact with a portion of the plastic body 2 which, in the example that is illustrated, directly forms a radiating element of said lighting device.

The Applicant has found that, within certain power ranges, arranging the printed circuit 12 on the plastic body 2 made of said plastic materials achieves an adequate level of heat dissipation to ensure effective cooling of the LEDs 9, despite the low thermal conductivity of this material.

The printed circuit 12 is placed in thermal contact with the flat rear wall 13 and, in particular, with a portion 22 thereof, which may be provided, on the side opposite to the side the printed circuit 12 faces, with a plurality of appendixes or fins 20 extending towards the outside of the plastic body 2 and which are suitable to promote the thermal exchange towards the outside of the plastic body 2. Purely by way of illustration, in the example that is shown the appendixes 20 have a rectangular cross-section and extend perpendicularly from the flat rear wall 13.

In more detail, the printed circuit 12 is arranged in thermal contact with a central portion 22 which may be made of a material with higher thermal conductivity than that of the plastic material forming the plastic body 2. The printed circuit 12 thus also has the function of transferring the heat generated by the junction of the LED source(s) 9 towards the dissipating element 22.

The material forming the central portion 22 is preferably a plastic material having high thermal conductivity (normally filled with ceramics and/or metals). The central portion 22 is preferably co-moulded (using conventional methods that are not described here) with the plastic material that forms the plastic body 2. Alternatively, the central portion 22 may be assembled to the plastic body by means of screws, clips or gluing and may be provided with a gasket.

According to an alternative embodiment of the central portion 22 made of a plastic material having high thermal conductivity, the printed circuit, and in particular the conductive tracks forming the circuit may be provided on said plastic material (or on appropriately insulated metal material, such as anodized aluminium) using serigraphic techniques. The conductive tracks forming the printed circuit are thus made by means of serigraphic techniques on the material that forms the portion 22 or said body 2 and the LEDs and the required respective electronic control components are directly welded on the body 2 to the respective tracks. This significantly reduces the thermal resistance (junction - outer environment) of the device. A thermal adhesive 24 (of a type that is known) is placed between the printed circuit 12 and the flat rear wall 13 to form a thermal interface between the printed circuit 12 and the rear wall 13 of the plastic body 2, or with the portion 22 thereof, and ensures the thermal connection.

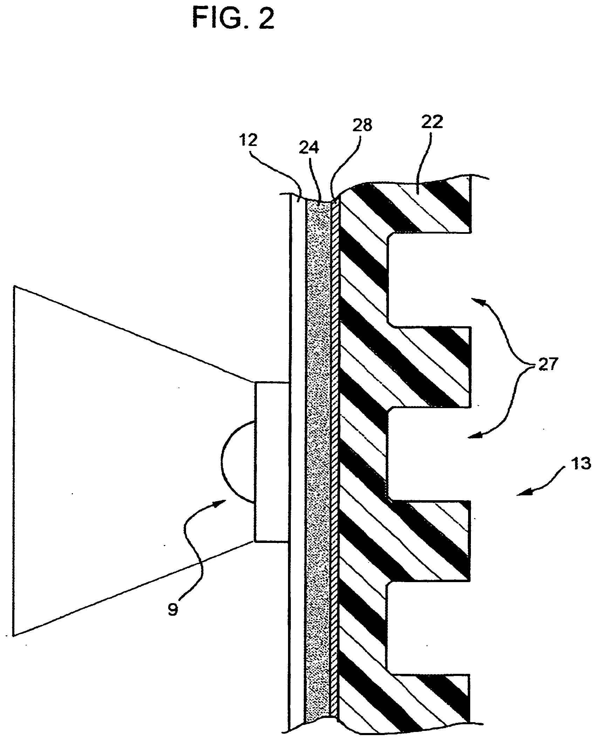

According to that illustrated in the alternative embodiment of figure 2, the flat rear wall 13 is provided with depressed seats 27 open towards the outside of the plastic body 2 so as to reduce the thickness of the material and improve dissipation. In the example shown in figure 2, the depressed seats 27, obtained on the dissipating element 23, consist of grooves with a rectangular cross-section.

According to the alternative embodiment, the surface of the rear wall 13 facing the printed circuit 12, in particular at least in correspondence with the depressed seats 27, is covered with a layer of metal material 28 of a suitable thickness, applied for example by means of a metallisation process to reduce the thermal power density (W/cm²) to be dissipated through the thickness of the body. According to this alternative embodiment, the layer 28 facilitates the distribution of the heat by conduction on the largest possible surface of the plastic body 2 while the presence of the depressed seats 27 creates portions of the wall in the plastic body 2 with a reduced thickness without any significant reduction in the strength thereof, which promote the exchange of the heat produced by the LEDs towards the outside of the plastic body 2.

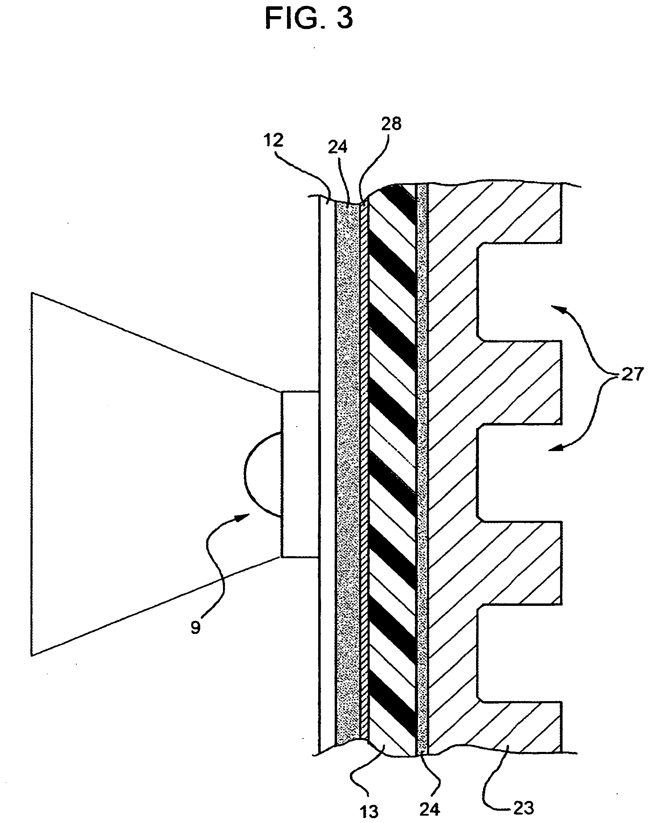

According to the alternative embodiment illustrated in figure 3 an additional dissipating element 23 is assembled on the rear wall 13 of the plastic body 2 to the outside thereof. To improve thermal dissipation, as described in figure 2, the surface of the rear wall 13 facing the printed circuit 12 may be covered with a layer of metal material 28. To improve thermal dissipation, a layer of thermal adhesive 24 is placed between the interfaces of the different elements of the device, and thus also between the additional dissipating element 23 on the outside of the body 2 and the rear wall 13 of the latter, said layer also serving to join the dissipating element 23 to the body 2, although other fastening means may also be used.

## Claims

1. A lighting device for vehicles, in particular motor vehicles, comprising a body (2) made of plastic material and defining a front opening (3) closed by a transparent element (5) and housing a light source (7) formed by one or more LEDs (9) arranged on a printed circuit (12)
wherein the printed circuit (12) is arranged in thermal contact with the plastic body (2) that forms a radiating element for the heat generated by the LEDs (9) and wherein conductive tracks forming said printed circuit are made by serigraphic techniques on the material that forms the body itself or a portion (22) thereof; said LEDs and the required respective electronic control components being directly welded on the body to the respective tracks;
**characterised in that** a dissipating element (23) is fixed to the outside of the rear wall (13) of the plastic body (2) by means of a thermal adhesive (24).

2. The device according to claim 1, wherein the printed circuit (12) is arranged in thermal contact with the body (2), or a portion thereof (22) which is provided, on the side opposite to the side the printed circuit (12) faces, with a plurality of appendixes (20) extending towards the outside of the plastic body (2) and which are suitable to promote the thermal exchange towards the outside of the plastic body (2).

3. The device according to claim 1 or 2, wherein said printed circuit (12) is arranged in thermal contact with a portion (22) of the plastic body, made of a material having a higher thermal conductivity than the plastic material forming the body (2).

4. The device according to claim 3, wherein the material forming said portion (22) is a plastic material having high thermal conductivity (filled with ceramics or metals).

5. The device according to one of claims 3 or 4, wherein said portion (22) is co-moulded with the plastic that forms said body (2).

6. The device according to claim 3 or 4, wherein said portion (22) is assembled to said plastic body (2) by gluing, or by means of screws/clips and gaskets.

7. The device according to anyone of the preceding claims, wherein are a portion (13) of the body (2) has depressed seats (27) to improve the thermal exchange towards the outside.

8. A vehicle provided with a lighting device according to any one of the preceding claims.

## Patentansprüche

1. Fahrzeugleuchte, insbesondere Kraftfahrzeugleuchte, die einen Körper (2) aufweist, der aus Kunststoffmaterial hergestellt ist und eine durch ein transparentes Element (5) geschlossene vordere Öffnung (3) definiert und eine Lichtquelle (7) aufnimmt, die durch eine oder mehr auf einer Leiterplatte (12) angeordnete LEDs (9) gebildet wird,
wobei die Leiterplatte (12) in thermischem Kontakt mit dem Kunststoffkörper (2), der ein abstrahlendes Element für die durch die LEDs (9) erzeugte Wärme bildet, angeordnet ist und wobei leitfähige Bahnen, die die Leiterplatte bilden, durch Siebdruckverfahren auf dem Material, das den Körper selbst oder einen Abschnitt (22) davon bildet, hergestellt sind; wobei die LEDs und die jeweiligen elektronischen Steuerungselemente, die erforderlich sind, direkt auf dem Körper mit den jeweiligen Bahnen verschweißt sind;
**dadurch gekennzeichnet, dass** ein abführendes Element (23) mittels eines Thermoklebstoffs (24) an der Außenseite der Rückwand (13) des Kunststoffkörpers (2) fixiert ist.

2. Vorrichtung nach Anspruch 1, wobei die Leiterplatte (12) in thermischem Kontakt mit dem Körper (2) oder einem Abschnitt davon (22) angeordnet ist, der auf der Seite gegenüber derjenigen, der die Leiterplatte (12) zugewandt ist, mit einer Vielzahl von Anhängen (20) versehen ist, die sich in Richtung der Außenseite des Kunststoffkörpers (2) erstrecken und geeignet sind, den Wärmeaustausch in Richtung der Außenseite des Kunststoffkörpers (2) zu fördern.

3. Vorrichtung nach Anspruch 1 oder 2, wobei die Leiterplatte (12) in thermischem Kontakt mit einem Abschnitt (22) des Kunststoffkörpers angeordnet ist, der aus einem Material mit einer höheren Wärmeleitfähigkeit als das Kunststoffmaterial, das den Körper (2) bildet, hergestellt ist.

4. Vorrichtung nach Anspruch 3, wobei das den Abschnitt (22) bildende Material ein Kunststoffmaterial mit hoher Wärmeleitfähigkeit (gefüllt mit Keramik oder Metallen) ist.

5. Vorrichtung nach Anspruch 3 oder 4, wobei der Abschnitt (22) mit dem Kunststoff, der den Körper (2) bildet, im Verbund gegossen ist.

6. Vorrichtung nach Anspruch 3 oder 4, wobei der Abschnitt (22) durch Kleben oder mittels Schrauben/Klemmen und Dichtungen an den Kunststoffkörper (2) gefügt ist.

7. Vorrichtung nach einem der voranstehenden Ansprüche, wobei ein Abschnitt (13) des Körpers (2) vertiefte Sitze (27) aufweist, um den Wärmeaustausch in Richtung der Außenseite zu verbessern.

8. Fahrzeug, versehen mit einer Leuchte nach einem der voranstehenden Ansprüche.

## Revendications

1. Dispositif d'éclairage destiné à des véhicules, et en particulier à des véhicules à moteur, comprenant un corps (2) composé d'un matériau plastique et définissant une ouverture avant (3) fermée par un élément transparent (5) et contenant une source de lumière (7) formée par une ou plusieurs LED (9) prévues sur un circuit imprimé (12),
dans lequel le circuit imprimé (12) est prévu en contact thermique avec le corps en plastique (2) qui forme un élément rayonnant pour la chaleur générée par les LED (9), et dans lequel des pistes conductrices qui forment ledit circuit imprimé sont créées par des techniques sérigraphiques sur le matériau qui forme le corps lui-même ou une partie (22) de celui-ci ; lesdites LED et les composants de commande électronique respectifs requis étant directement soudés sur le corps, sur les pistes respectives ; **caractérisé en ce qu'**un élément de dissipation (23) est fixé sur l'extérieur de la paroi arrière (13) du corps en plastique (2) à l'aide d'un adhésif thermique (24).

2. Dispositif selon la revendication 1, dans lequel le circuit imprimé (12) est prévu en contact thermique avec le corps (2), ou une partie de celui-ci (22) qui est munie, sur le côté opposé au côté vers lequel le circuit imprimé (12) est tourné, d'une pluralité d'appendices (20) qui s'étendent vers l'extérieur du corps en plastique (2) et qui sont adaptés pour promouvoir l'échange thermique vers l'extérieur du corps en plastique (2).

3. Dispositif selon la revendication 1 ou 2, dans lequel ledit circuit imprimé (12) est prévu en contact thermique avec une partie (22) du corps en plastique, composée d'un matériau qui présente une conductivité thermique plus élevée que le matériau en plastique qui forme le corps (2).

4. Dispositif selon la revendication 3, dans lequel le matériau qui forme ladite partie (22) est un matériau en plastique qui présente une conductivité thermique élevée (rempli avec de la céramique ou des métaux).

5. Dispositif selon l'une des revendications 3 ou 4, dans lequel ladite partie (22) est co-moulée avec le plastique qui forme ledit corps (2).

6. Dispositif selon la revendication 3 ou 4, dans lequel ladite partie (22) est assemblée sur ledit corps en plastique (2) par collage, ou à l'aide de vis/de clips et de joints.

7. Dispositif selon l'une quelconque des revendications précédentes, dans lequel une partie (13) du corps (2) possède des sièges renfoncés (27) afin d'améliorer l'échange thermique vers l'extérieur.

8. Véhicule muni d'un dispositif d'éclairage selon l'une quelconque des revendications précédentes.
